# EUROPEAN PATENT SPECIFICATION

(11) **EP 0 469 929 B1**
(45) Date of publication and mention of the grant of the patent: **29.11.1995**
(21) Application number: 91307143.7
(22) Date of filing: 02.08.1991
(51) Int. Cl.: H01S 3/103, G11B 7/125, G06K 1/12

(54) **Controlling currents in laser diodes**
Steuerung von Strömen in Laserdioden
Commande des courants d'un diode à laser

(30) Priority: 02.08.1990 JP 205549/90
(43) Date of publication of application: 05.02.1992
(73) Proprietor: FUJITSU LIMITED, Kawasaki-shi, Kanagawa 211 (JP)
(72) Inventor: Minami, Akira, Inagi-shi, Tokyo 206 (JP); Sasaki, Masateru, Yokohama-shi, Kanagawa 226 (JP)
(74) Representative: Fane, Christopher Robin King

(56) References cited:
- EP-A- 0 082 357
- EP-A- 0 223 576
- US-A- 4 811 329
- PATENT ABSTRACTS OF JAPAN,vol. 11, no. 19 (P-537)20 January 1987;& JP-A-61192043
- PATENT ABSTRACTS OF JAPAN,vol. 11, no. 164 (P-580)27 May 1987;& JP-A-61296539
- PATENT ABSTRACTS OF JAPAN,vol. 11, no. 367 (E-561)28 November 1987;& JP-A-62140482

## Description

The present invention relates to controlling currents in laser diodes.

In an optical storage device, circuitry may be provided for supplying a current to a laser diode of the device to cause the laser diode to emit light that can be used for reading digital data from an optical storage medium and for writing (recording) digital data thereon. Such an apparatus is disclosed in EP-A-O 223 576.

Many optical storage devices using optical storage media, such as optical disks, optomagnetic disks, or optical memory cards have been developed. In such an optical storage device, a laser diode is used as a light source when carrying out a read operation and a write (or erase) operation. For example, during a write mode, a laser beam is made incident on an area of a magnetic film of an optical storage medium which has been premagnetized and, as a result, that area of the magnetic film is heated and, accordingly, the direction of magnetization therein is inverted by the effect of magnetization of adjacent areas thereof. Also, during an erase mode, a laser beam is made incident on an area of the magnetic film, so as to heat that area, which area is then magnetized by using an external bias magnetic field. During a write or erase mode, a laser beam is used as a source of heat, and driving a laser diode to generate such heat requires a large amount of energy. On the other hand, during a read mode, a laser beam is made incident on an area of the magnetic film, and read data can be determined by a change in a plane of polarisation of reflected light, due to the Kerr effect. During a read mode, a laser diode for generating a laser beam is driven by a small amount of energy.

When the laser diode is driven by a small amount of energy, the output level of the laser diode is in a noise region, and the S/N ratio of a reproduced signal is low. Therefore, to enhance this S/N ratio, a current supplied to the laser diode can be modulated by a high frequency signal having a frequency much higher than a frequency used for recording data in the magnetic film, thereby increasing the peak value of current supplied to the laser diode without increasing the effective light output power therefrom.

Also, to suppress fluctuations in the output of light emitted from the laser diode, an automatic power control (APC) may be adopted, to bring a mean value of a light output during a read mode and a minimum light output (called a base read output) during a write mode close to a desired level.

In the above-mentioned laser diode drive system using an APC, although the desired level of the APC is not changed even when the control is transferred from a read mode to a write (or erase) mode, or vice versa, the drive current of the APC is changed, since the drive current of the laser diode, i.e. the energization thereof during a read mode is AC and the current provided during a write mode for a base read output is DC. Therefore, upon a switching between a read mode and a write (or erase) mode, the control of the light output is unstable due to a delay in the response caused by a time-constant of the APC, thus reducing speed of access to the optical storage medium, as later explained in detail.

According to a first aspect of the present invention, there is provided laser diode control circuitry, for driving a laser diode to emit light for reading digitally recorded data from an optical storage medium and recording data digitally on that medium, comprising:
first current supply means operable to supply a first direct current continually to the laser diode during such reading and recording;
second current supply means connected for supplying a second direct current continually to the laser diode during such recording, so that the power output of the laser diode due to the said first and second direct currents together is substantially equal to a preselected base read power;
third current supply means operable to supply a third current, pulsed at a high frequency, continually to the laser diode during such reading;
light power monitoring means, arranged to receive light emitted by the laser diode, for providing an output depending on the received light power;
automatic power control means, connected between the said light power monitoring means and the said first current supply means, operable to control the magnitude of the said first direct current, during such reading, so as to maintain the mean value of the optical output power of the laser diode substantially equal to the said base read power;
fourth current supply means, for supplying a fourth direct current to the laser diode, in addition to the said first and second direct currents, when data is to be recorded on the said medium; and
switching means operable to switch the said fourth current supply means on and off in accordance with write data to be recorded on the said medium.

According to a second aspect of the present invention, there is provided laser diode control circuitry, for driving a laser diode to emit light for reading digitally recorded data from an optical storage medium and recording data digitally on that medium, comprising:
first current supply means operable to supply a first direct current continually to the laser diode during such reading and recording;
second current supply means operable to supply a second current continually to the laser diode during such recording and to supply that second current, pulsed at a high frequency, to the laser diode during such reading;
light power monitoring means, arranged to receive light emitted by the laser diode, for providing an output depending on the received light power;
automatic power control means, connected between the said light power monitoring means and the said first current supply means, operable to control the magnitude of the said first direct current, during such reading, so as to maintain the mean value of the optical output power of the laser diode substantially equal to a preselected base read power;
third current supply means, for supplying a third current to the laser diode, in addition to the said first and second currents, when data is to be recorded on the said medium;
switching means operable to switch the said third current supply means on and off in accordance with write data to be recorded on the said medium; and
current absorbing means for partially cancelling the effect, on the optical power output of the laser diode, of the second current when data is being recorded on the said medium, so that the said power output of the laser diode is substantially equal to a predetermined write power.

In an embodiment of the present invention, a first direct current is supplied to a laser diode during read and write modes, and this current is less than, or equal to, a threshold current (minimum current) which causes the laser diode to emit light. During a read mode, a read peak current, pulsed by a high frequency signal, is supplied to a laser diode in addition to the first direct current, and during a write mode, a base read current is supplied to the laser diode in addition to the first direct current, so that the light output of the laser diode is substantially equal to a preselected base read output. The read peak current is adjusted so that a main value of the light output of the laser diode is equal to the base read output, and an automatic control is performed upon the amount of current so that the light output of the laser diode is close to the base read output. As a result, when the control is transferred from a read mode to a write (or erase) mode, or vice versa, since the mean value (effective value) of the light output during the read mode is close to the light output (base read power) during the write mode, the drive current of the laser diode is not substantially changed. Therefore, the monitored output of light is not substantially changed, and thus the operation of the APC is stable. Thus, even after the control is switched, a read or write access can be initiated immediately.

In an erase mode, although the light output is considerably larger than the base readc output, current can be absored by other means from a monitored light output (current) supplied to the APC. Accordingly, the operation of the APC can be acceptably stable at a switching of the control from a read mode to an erase mode or vice versa.

Reference will now be made, by way of exammple, to the accompanying drawings wherein:
Fig. 1 is a block circuit diagram illustrating a previously-considered apparatus for supplying a current to a laser diode;
Fig. 2 is a graph illustrating a supplied current vs. light output characteristic of the apparatus of Fig. 1;
Figs. 3A and 3B are timing diagrams relating to operation of the apparatus of Fig. 1:
Fig. 4 is a circuit diagram illustrating apparatus for supplying a current to a laser diode according to a first embodiment of the present invention;
Fig. 5 is a logic circuit diagram of a gate circuit shown in Fig. 4;
Fig. 6 is a circuit diagram of an APC circuit shown in Fig. 1;
Fig. 7 is a circuit diagram of an example of a control current source (voltage/current conversion circuit) shown in Fig. 4;
Fig. 8 is a circuit diagram of an example of a current switch shown in Fig. 4;
Figs. 9 to 14 are flowcharts relating to operation of a microcomputer shown in Fig. 4;
Fig. 15 is a graph showing a current supplied vs. light output characteristic of the apparatus of Fig. 4;
Fig. 16 is a circuit diagram illustrating apparatus for supplying a current to a laser diode according to a second embodiment of the present invention;
Fig. 17 is a logic circuit diagram of a gate circuit shown in Fig. 16;
Figs. 18 and 19 are flowcharts relating to operation of a microcomputer shown in Fig. 16, and
Fig. 20 is a graph showing a current supplied vs. light output characteristic of the apparatus of Fig. 16.

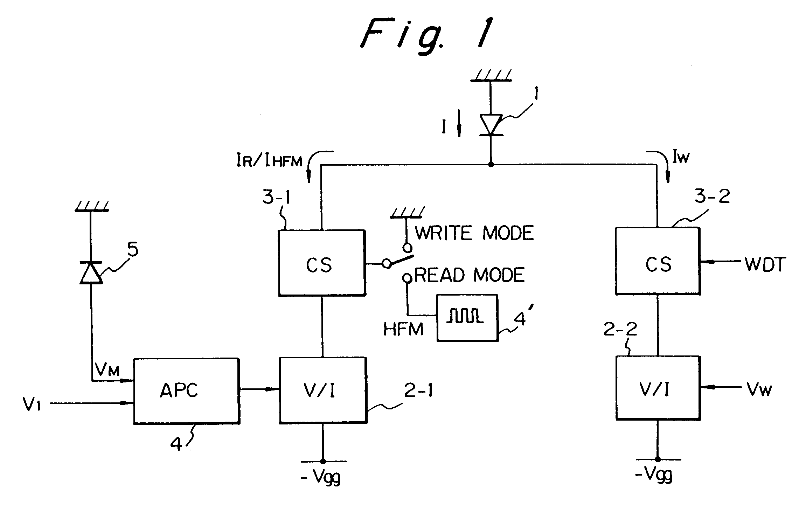

In the apparatus for supplying a current shown in Fig. 1, a laser diode 1 is connected to two parallel control circuit sources (voltage to current conversion circuits) 2-1 and 2-2, which receive voltages V₁ and V_{w} respectively from a microcomputer or the like (not shown).

The control current sources 2-1 and 2-2 are switched by current switches 3-1 and 3-2 respectively.

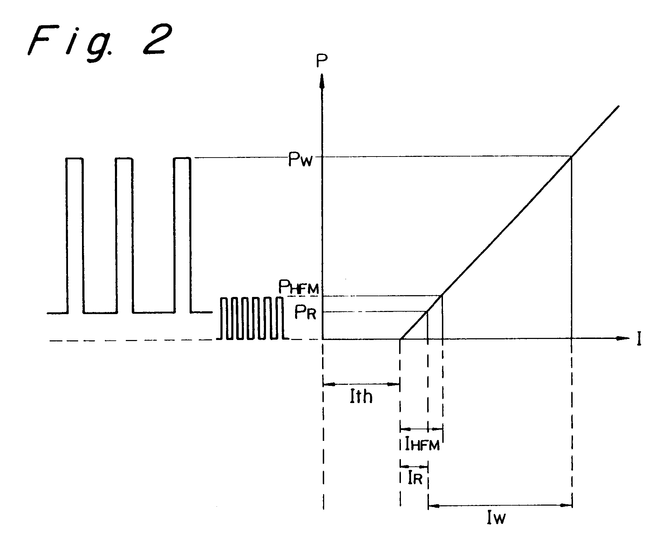

During a read mode, the current switch 3-1 is switched on and off by a high frequency signal HFM, supplied from a high frequency signal generator 4′. The frequency of the high frequency signal HFM is much higher than a frequency used for recording data on the optical storage medium (not shown). As a result, a pulsed current, having a read peak current value I_{HFM}, is supplied to the laser diode 1 in addition to a threshold current Iₜₕ, thereby to cause the laser diode to emit a read peak output power P_{HFM}, as shown in Fig. 2.

During a write mode for data "0" (WDT = "0"), a base read current I_{R} is supplied to the laser diode 1 in addition to the threshold current Iₜₕ, so that the light power emitted by the laser diode equals a preselected base read output power P_{R}, as shown in Fig. 2.

During a write mode for data "1" (WDT = "1"), the current switch 3-2 is turned ON by a write data signal WDT, and as a result a write current I_{W} is added to the current (Iₜₕ + I_{R}) flowing through the laser diode 1, so that the output power of the diode equals a write output power P_{W}, as shown in Fig. 2.

During an erase mode the current switch 3-1 is operated as under a write mode, and the current switch 3-2 is operated as under the write mode for write data "1" (WDT = "1"), and therefore a current Iₜₕ + I_{R} + I_{W} is continuously supplied to the laser diode 1.

An APC circuit 4 controls a current flowing through the current source 2-1 so that a voltage V_{M}, corresponding to light output of the laser diode 1 monitored by a photo diode 5, is close to a voltage VR corresponding to the base read output P_{R}. Thus, fluctuation of the light output of the laser diode 1 due to change of temperature, elapse of time, and the like can be compensated for.

In the Fig. 1 apparatus, however, when control is transferred from a read mode to a write mode, or vice versa, the output of the laser diode 1, controlled by the APC circuit 4, may fluctuate undesirably.

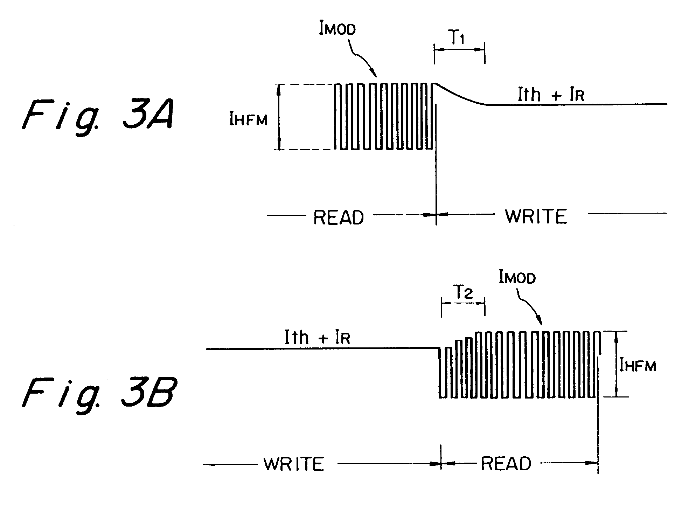

For example, as shown in Fig. 3A, when control is transferred from a read mode to a write mode for data "0", a current supplied to the laser diode 1 is changed from a modulated current I_{MOD} to a constant current Iₜₕ + I_{R}, even when the voltage V_{R} is constant. As a result, the light output of the laser diode 1 is caused to fluctuate, thereby introducing noise into the monitored output supplied to the APC circuit 4. This can cause the operation of the APC circuit 4 to become unstable. Such unstable operation of the APC circuit 4 continues for a time T₁, which depends on a time constant of the APC circuit 4 and during this time T₁, it may be impossible to obtain a write access to the optical storage medium. At worst, initiation of such a write access may not be possible until after one more rotation of the optical storage medium.

Similarly, as shown in Fig. 3B, when control is transferred from a write mode for data "0" to a read mode, a current supplied to the laser diode 1 is changed from the constant current Iₜₕ + I_{R} to the modulated current I_{MOD} even when the voltage V₁ is constant. As a result, the light output of the laser diode 1 is caused to fluctuate; thereby introducing noise into the monitored power supplied to the APC circuit 4. This can cause the operation of the APC circuit 4 to become unstable. Such unstable operation of the APC circuit 4 continues for a time T₂, depending on the time constant of the APC circuit 4, and during this time T₂ it is impossible to obtain a read access to the optical storage medium, thereby possibly preventing initiation of such a read access until after one more rotation of the optical storage medium.

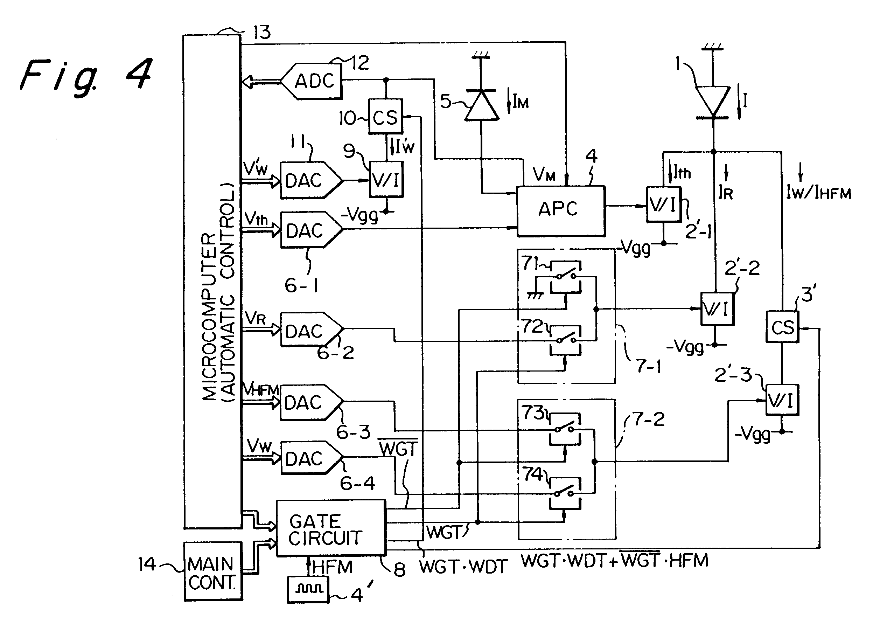

In Fig. 4, which shows a first embodiment of the present invention, three control current sources 2′-1, 2′-2 and 2′-3 are provided, and a current switch 3′ is connected in series with the control current source 2′-3.

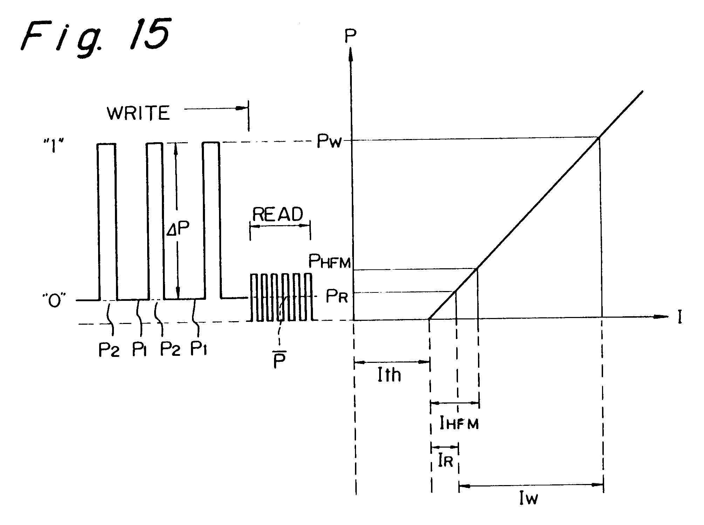

The control current source 2′-1 is used for supplying a threshold current (minimum current) Iₜₕ (see Fig. 15) at which the laser diode 1 emits light. The APC circuit 4 is connected to the control current source 2′-1, to enable automatic power control to be carried out for the threshold current Iₜₕ in accordance with a difference between a voltage Vₜₕ, supplied by a digital/analogue (D/A) converter 6-1, and a monitored voltage V_{M} supplied by a photo diode 5. The control current source 2′-2 is used for supplying a base read current I_{R} (see Fig. 15) to the laser diode 1 during a write mode (WGT = "1"), whilst not supplying any current during a read mode (W̅G̅T̅ = "1"). For this purpose, a switching circuit 7-1 formed by two switches 71 and 72 is provided. During a write mode, when a gate signal WGT (= "1") is supplied from a gate circuit 8 to the switch 72, a voltage V_{R} corresponding to the base read current I_{R} is applied by a D/A converter 6-2 to the control current source 2′-2. Note that, when a current Iₜₕ + I_{R} is supplied to the laser diode 1, the light output is the base read output power P_{R} (see Fig. 15). On the other hand, during a read mode, when a gate signal W̅G̅T̅ (= "1") is supplied from the gate circuit 8 to the switch 71, 0 V is applied to the control current source 2′-2.

The control current source 2′-3 is used for supplying a read peak current I_{HFM} (see Fig. 15) during a read mode (W̅G̅T̅ = "1") and supplying a write current I_{W} during a write mode for data "1" (WGT = WDT = "1"). For this purpose, a switching circuit 7-2 formed by two switches 73 and 74 is provided. That is, during a read mode, when the gate signal W̅G̅T̅ (= "1") is supplied to the switch 73, a voltage V_{HFM} corresponding to the read peak current I_{HFM} is supplied by a D/A converter 6-3 to the control current source 2′-3. Also, in this case, the current switch 3′ is switched by the high frequency signal HFM, and therefore the read peak current I_{HFM} is modulated by the high frequency signal HFM. Note that, when a current Iₜₕ + I_{HFM} is supplied to the laser diode 1, the light output is the read peak output P_{HFM} (see Fig. 15). On the other hand, during a write mode for data "1", when the gate signal WGT (= "1") is supplied to the switch 74, a voltage V_{W} corresponding to the write current I_{W} is applied by a D/A converter 6-4 to the control current source 2′-3. Also, in this case, the current switch 3′ is turned ON by the signal WGT.WDT (= "1"). Note that, when a current Iₜₕ + I_{R} + I_{W} is supplied to the laser diode 1, the light output is the write output power P_{W} (see Fig. 15).

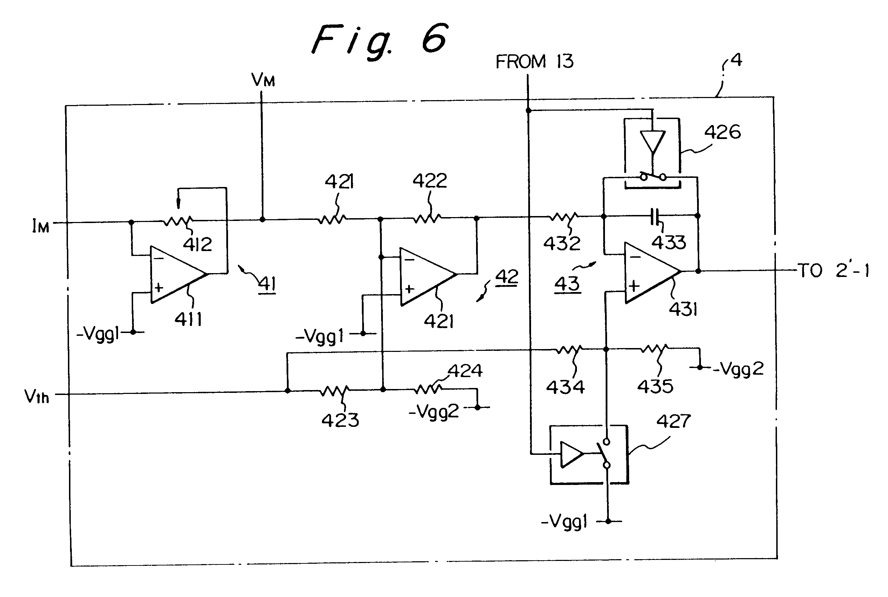

A threshold voltage Vₜₕ, from the D/A converter 6-1, is applied to one input of the APC circuit 4 and a monitored power voltage V_{M} is applied to another input of that APC circuit 4. The threshold current Iₜₕ flowing through the control current source 2′-1 can be adjusted by the APC circuit 4 so that the monitored light output voltage V_{M} is brought close to the threshold voltage Vₜₕ. Note that a current to voltage conversion circuit is actually required to convert a current I_{M} flowing through the photo diode 5 to the monitored output voltage V_{M} at an input stage of the APC circuit 4, but such a conversion circuit is omitted to simplify the circuit diagram. Also, such a conversion circuit can be included in the APC circuit 4 (see Fig. 6).

A control current source 9 and a current switch 10 are connected in series to the photo diode 5. Such a write mode for data "1", when a gate signal WGT.WDT is supplied to the current switch 10, a voltage V_{W}′, corresponding to the write current I_{W} is applied by a D/A converter 11 to the control current source 9. Therefore, even when a write current I_{W} is added to the current flowing through the laser diode 1, an increase in the monitored output voltage V_{M} due to the write current I_{W} is absorbed by the control current source 9. Therefore, during a write mode (WGT = "1"), the monitored light output voltage V_{M} is maintained at a value corresponding to the base read output power P_{R} regardless of the write data. In this case, a voltage V_{W}′ corresponding to the above-mentioned increase represented by a current I_{W}′ is applied by the D/A converter 11 to the control voltage source 9. Thus, abnormal operation of the APC circuit 4, due to the write current I_{W}, can be avoided.

An A/D converter 12 samples the monitored output voltage V_{M}. Also, in this case, note that a current to voltage conversion circuit is actually required to convert the current I_{M} flowing through the photo diode 5 to the monitored output voltage V_{M} at an input stage of the A/D converter 12, but such a conversion circuit is omitted for the sake of simplicity.

A microcomputer 13, which may be formed by a central processing unit (CPU), a read-only memory (ROM), a random access memory (RAM), and the like, is provided for controlling the various elements in Fig. 4. This microcomputer 13 is used only for automatic adjustment of the voltages Vₜₕ, V_{R}, V_{HFM}, V_{W} and V_{W}′.

A main controller 14 is provided for actually performing a read, write, or erase operation at the optical storage medium, after automatic adjustment by the microcomputer 13.

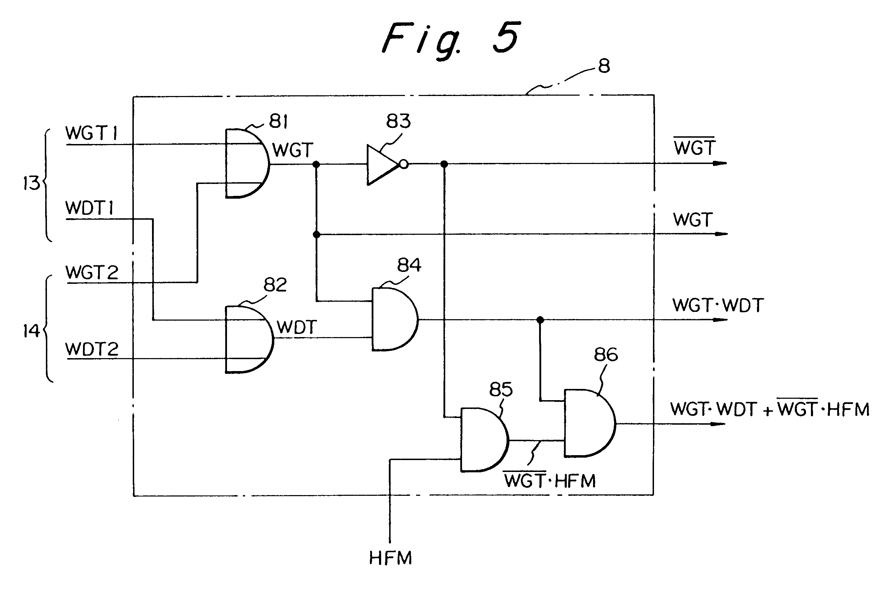

The gate circuit 8 can be operated by both the microcomputer 13 and the main controller 14, as illustrated in Fig. 5.

During a write mode, the microcomputer 13 of Fig. 5 supplies a gate signal WGT1 and a write data signal WDT1 to the gate circuit 8, and the main controller supplies a gate signal WGT2 and a write data signal WDT2. Also, a high frequency signal HFM is supplied to the gate circuit 8.

The gate circuit 8 includes two OR circuits 81 and 82, an inverter 83, two AND circuits 84 and 85, and an OR circuit 86. The OR circuit 81 generates a gate signal WGT (= "1"), when the microcomputer 13 generates a gate signal WGT1 (= "1") or when the main controller 14 generates a gate signal WGT2 (= "1"). In other words, when one of the microcomputer 13 and the main controller 14 is in a write mode, the OR circuit 81 generates the gate signal WGT (= "1"). Similarly, the OR circuit 82 generates a write data signal WDT (= "1") when the microcomputer 13 generates a write data signal WDT1 (= "1"), or when the main controller 14 generates a write data signal WDT2 (= "1").

The inverter 83 inverts the output WGT of the OR circuit 81 and accordingly, generates a gate signal W̅G̅T̅. Also, the output WGT of the OR circuit 81 is directly output.

Since the AND circuit 84 is connected to the outputs of the OR circuits 81 and 82, the AND circuit 84 generates a gate signal WGT.WDT.

Also, since the AND circuit 85 is connected to the inverter 83 and receives the high frequency signal HFM, the AND circuit 85 generates a gate signal W̅G̅T̅.HFM.

Further, since the OR circuit 86 is connected to the outputs of the AND circuits 84 and 85, the OR circuit 86 generates a gate signal WGT.WDT + W̅G̅T̅.HFM.

Thus, the gate signals WGT, WGT, WGT.WDT and WGT.WDT + W̅G̅T̅.HFM are generated by the gate circuit 8.

In Fig. 6, which is a detailed circuit diagram of the APC circuit 4 of Fig. 4, the APC circuit 4 includes a differential amplifier 41 for converting a current I_{M} flowing through the photo diode 5 into a voltage which is already indicated by V_{M}, a differential amplifier 42 for generating a difference signal between the light output voltage V_{M} from the differential amplifier 41 and the threshold voltage Vₜₕ from the D/A converter 6-1, and an integrator 43. In more detail, the differential amplifier 41 is formed by an operational amplifier 411 and a variable resistor 412. If the current I_{M} increases, so that the current flowing through the resistor 412 increases, a voltage between the terminals thereof also increases. Thus, the differential amplifier 41 generates a voltage V_{M} depending on the current I_{M} with reference to -V_{gg1}. Also, the differential amplifier 42 is formed by an operational amplifier 421 and resistors 421 to 424. Also, the integrator 43 is formed by an operational amplifier 431, a resistor 432, a capacitor 433, resistors 434 and 435, and switches 426 and 427 controlled by the microcomputer 13.

The switch 426 is connected in parallel with the capacitor 433, and the switch 427 is connected with a non-inverting input of the operational amplifier 431. To turn OFF the APC circuit 4, the microcomputer 13 turns ON the switch 426 and turns OFF the switch 427 as illustrated in Fig. 6, so that the integrator 43 serves as a voltage buffer, thereby applying the threshold voltage Vₜₕ to the control current source 2′-1. On the other hand, to carry out an APC, the microcomputer 13 turns OFF the switch 426 and turns ON the switch 427, so that the integrator 43 forms an actual integrator.

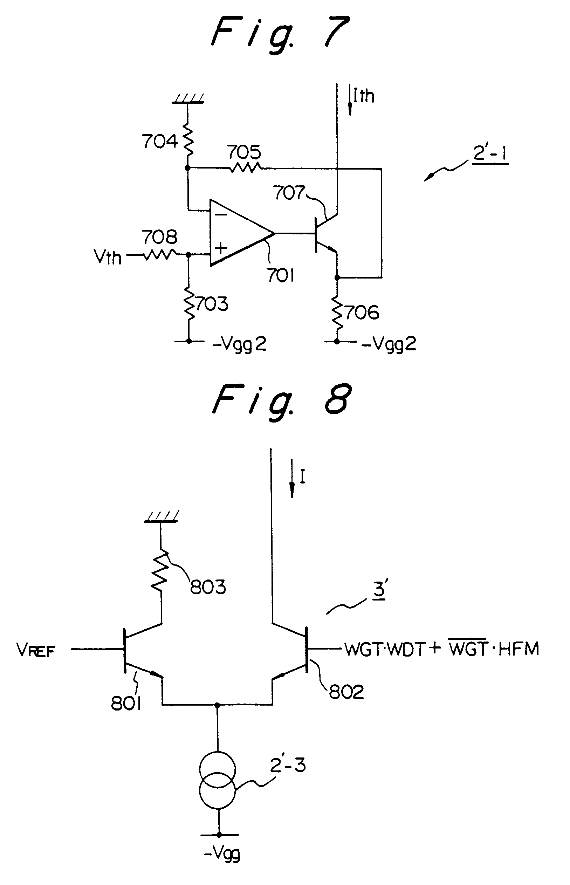

In Fig. 7, which illustrates an example of the control current source such as 2′-1 of Fig. 4, the control current source 2′-1 includes an operational amplifier 701, resistors 702 through 706, and an output transistor 707. Therefore, if the voltage Vₜₕ increases, the current flowing through the resistor 705 will increase, thereby increasing the base-emitter voltage V_{BE} of the output transistor 707. Thus, the current Iₜₕ flowing through the output transistor 707 is dependent on the voltage Vₜₕ. In other words, the voltage Vₜₕ is converted to the threshold current Iₜₕ.

In Fig. 8, which illustrates an example of the current switches such as 3′ of Fig. 4, the current switch 3′ includes two NPN transistors 801 and 802 having a common emitter connected to a current source which is, in this case, the control current source 2′-3. Also, a resistor 803 is connected between a collector of the transistor 801 and a power supply line such as a ground line. Further, a reference voltage V_{REF} is applied to a base of the transistor 901, and a gate signal such as WGT.WDT + W̅G̅T̅.HFM is applied to a base of the transistor 802. Therefore, if the potential of the gate signal is lower than that of the reference voltage V_{REF}, the transistor 801 is turned ON and the transistor 802 is turned OFF, so that a current I does not flow. Conversely, if the potential of the gate signal is higher than the reference voltage V_{REF}, the transistor 801 is turned OFF and the transistor 802 is turned ON, so that a current I determined by the control current source 2′-3 flows through the transistor 802.

When power is supplied to the microcomputer 13, the microcomputer 13 carries out an automatic control, as explained below.

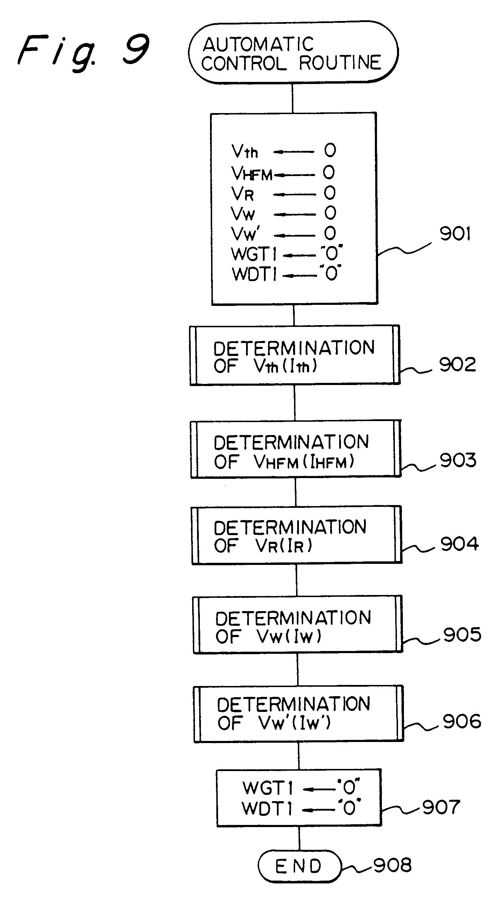

Fig. 9 shows how an automatic control routine is carried out after the power supply to the microcomputer 13 is turned ON, at step 901, and an initialization is carried out. In particular, the contents of Vₜₕ, V_{HFM}, V_{R}, V_{M} and V_{W}′ in the RAM are cleared, and the data WGT1 and WDT1 in the RAM are reset.

At step 902, the value Vₜₕ (i.e. Iₜₕ) for the D/A converter 6-1 is determined, and at step 903, the value V_{HFM} (i.e. I_{HFM}) for the D/A converter 6-3 is determined. In step 904, the value V_{R} (i.e. I_{R}) for the D/A converter 6-2 is determined, and at step 905 the value V_{W} (i.e. I_{W}) for the D/A converter 6-4 is determined. Further, at step 906 the value V_{W}′ (i.e. I_{W}′) for the D/A converter 11 is determined. Steps 902 through 907 will be explained later in more detail.

At step 907, the data WGT1 and WDT1, which are set at steps 904 and 905, are reset (= "0").

Then, the routine of Fig. 9 is completed at step 908.

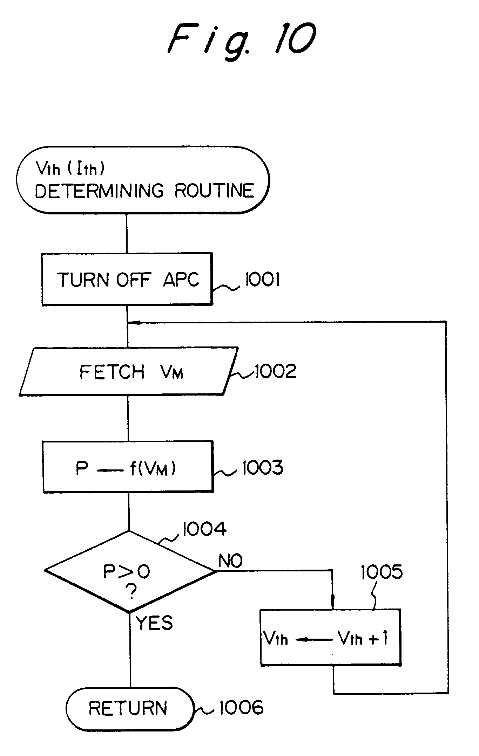

In Fig. 10, which is a detailed flowchart of the Vₜₕ (Iₜₕ) determining step 902, the microcomputer 13 turns OFF the APC circuit 4 at step 1001, so that the threshold voltage Vₜₕ, which is initially O V, is supplied from the D/A converter 6-1 directly to the control current source 2′-1. At step 1002, a monitored voltage V_{M} is fetched from the A/D converter 12, and at step 1003, a power P of the laser diode 1 is calculated from the voltage V_{M} in accordance with a predetermined function f.

At step 1004, it is determined whether or not P is larger than O, i.e. whether or not the laser diode 1 has started to emit light. If P ≦ 0, control proceeds to step 1005, which increases the value Vₜₕ by a definite value such as 1, and the control steps 1002 to 1004 are then repeated. Otherwise, control proceeds to step 1006, thus completing the routine of Fig. 10. The value Vₜₕ, and hence the threshold current Iₜₕ, is determined by the routine of Fig. 10, and is stored in the RAM.

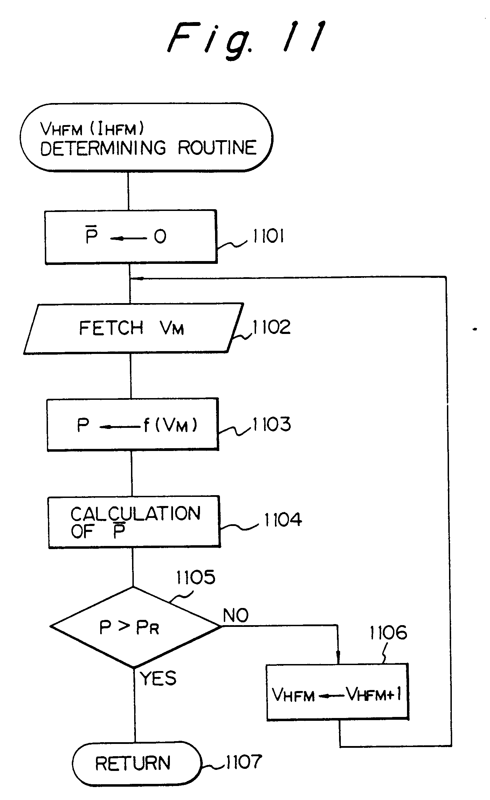

In Fig. 11, which is a detailed flowchart of the V_{HFM} (I_{HFM}) determining step 903, since the data WGT1 is already reset (WGT1 = "0") and the data WGT2 of the main controller 14 is also reset (WGT2 = "0"), V_{HFM}, which is initially O V, is supplied from the D/A converter 6-3 via the switch 73 to the control current source 2′-3. Also, the gate signal WGT.WDT + W̅G̅T̅.HFM of the gate circuit 8 represents HFM, and therefore the current switch 3′ is switched by the high frequency signal HFM.

First, at step 1101, a mean value P̅ of the monitored power P is reset to zero.

Then, at step 1102, a monitored output voltage V_{M} is fetched from the A/D converter 12 and, at step 1103, power P of the laser diode 1 is calculated from the voltage V_{M}, in accordance with the predetermined function f.

At step 1104, the mean value P̅ of the monitored power P is calculated by$\overline{\text{P}} \text{←} \frac{\text{n.} \overline{\text{P}} \text{+ P}}{\text{n + 1}}$
where n is a positive integer such as 3, 7, 15, .... Of course, other calculation methods can be adopted. Note that in this case the monitored power P is an alternating current.

At step 1105, it is determined whether or not the mean value P̅ of the monitored power P is larger than a base read output power P_{R}, i.e. whether or not the mean value P̅ equals the base read output power P_{R}. If P ≦ P_{R} control proceeds to step 1206, which increases the value V_{HFM} by a definite value such as 1, and steps 1102 to 1105 are then repeated. Otherwise, control proceeds to step 1107, thereby completing the routine of Fig. 11. Thus, the value V_{HFM} and hence the read peak current I_{HFM}, is determined by the routine of Fig. 11 and is stored in RAM.

Note that, when carrying out the routine of Fig. 11, a current I = Iₜₕ + I_{HFM} is supplied to the laser diode 1.

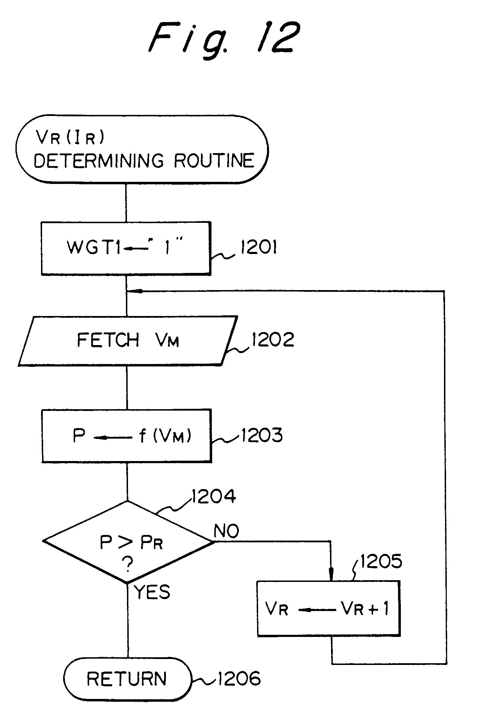

In Fig. 12, which is a detailed flowchart of V_{R} (I_{R}) determining step 904, at step 1201, the gate signal WGT1 is set (WGT1 = "1"). As a result, the value V_{R}, which is initially 0 V, is supplied from the D/A converter 6-2 via the switch 72 to the control current source 2′-2. Also, the gate signal WGT.WDT + W̅G̅T̅.HFM of the gate circuit 8 represents "0", since WGT = "1", WDT = "0" and W̅G̅T̅ = "0". Therefore, the current switch 3′ is turned OFF.

At step 1202, a monitored output voltage V_{M} is fetched from the A/D converter 12, and at step 1203, a power P of the laser diode 1 is calculated from this voltage V_{M} in accordance with the predetermined function f.

At step 1204, it is determined whether or not P is larger than P_{R}, i.e. whether or not the light power P equals the base read output power P_{R}. If P ≦ P_{R}, control proceeds to step 1205 which increases the value V_{R} by a definite value such as 1, and steps 1202 to 1204 are then repeated. Otherwise control proceeds to step 1206, thereby completing the routine of Fig. 12. Thus, the value V_{R} for the base read output power P_{R} is finally determined by the routine of Fig. 12, and is stored in the RAM.

Note that, when carrying out the routine of Fig. 12, a current I = Iₜₕ + I_{R} is supplied to the laser diode 1.

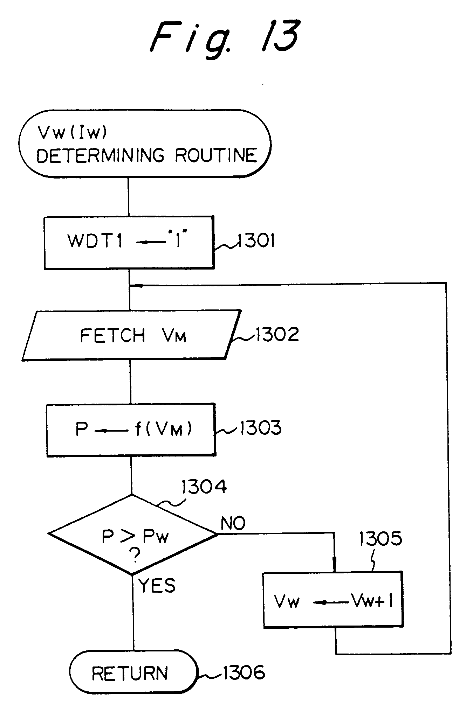

In Fig. 13, which is a detailed flowchart of the V_{W} (I_{W}) determining step 905, at step 1301, the data signal WDT1 is set (WDT1 = "1"). As a result, the gate signal WGT.WDT + W̅G̅T̅.HFM of the gate circuit 8 represents "1", since WGT = "1", WDT = "1" and W̅G̅T̅ = "0". Therefore, the current switch 3" is turned ON. Also, in this case, since the gate signal WGT of the gate circuit 8 is "1", the value V_{W}, which is initially O V, is supplied from the D/A converter 6-4 via the switch 74 to the control current source 2′-3.

At step 1302, a monitored output voltage V_{M} is fetched from the A/D converted 12 and, at step 1403, a power P of the laser diode 1 is calculated from this output voltage V_{M}, in accordance with the predetermined function f.

At step 1304, it is determined whether or not P is larger than P_{W}, i.e. whether or not the light power P reaches the write power P_{W}. If P ≦ P_{W}, control proceeds to step 1205 which increases the value V_{W} by a definite value such as 1, and steps 1402 to 1404 are then repeated. Otherwise, the control proceeds to step 1406, thereby completing the routine of Fig. 13. Thus, the value V_{W} for the write output P_{W} is finally determined by the routine of Fig. 13, and is stored in the RAM.

Note that, when carrying out the routine of Fig. 13, a current I = Iₜₕ + I_{R} + I_{W} is supplied to the laser diode.

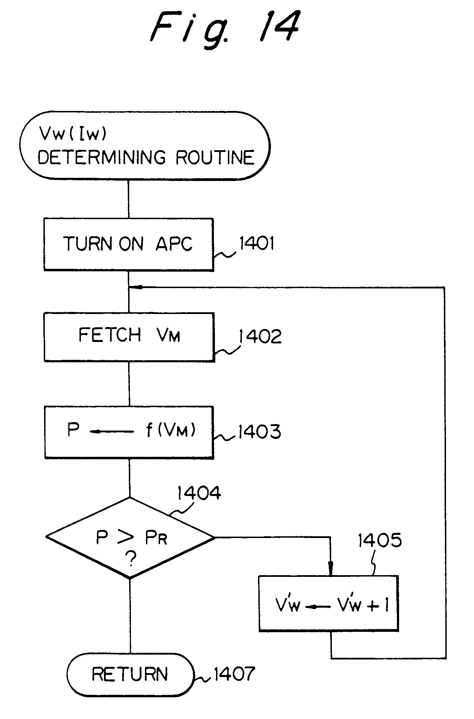

In Fig. 14, which is a detailed flowchart of V_{W}′ (I_{W}′) determining step 906, at step 1401, the microcomputer 13 turns ON the APC circuit 4.

At step 1402, a monitored output voltage V_{M} is fetched from the A/D converter 12, and at step 1403, a power P of the laser diode 1 is calculated from this output voltage V_{M} in accordance with the predetermined function f.

At step 1404, it is determined whether or not P is larger than P_{R}, i.e. whether or not the light power P is equal to the base read output power P_{R}. If P ≦ P_{R}, control proceeds to step 1405 which increases the value V_{W}′ by a definite value such as 1, and the control at steps 1402 through 1404 is then repeated. Otherwise, the control proceeds to step 1406, thus completing the routine of Fig. 14. Thus, the value V_{W}′ for an increased power due to the write current I_{W} is finally determined by the routine of Fig. 14, and is stored in the RAM.

Note that, when carrying out the routine of Fig. 14, a current I = Iₜₕ + I_{R} + I_{W} is supplied to the laser diode 1.

The operation of the main controller 14 of Fig. 4 will be explained with reference to Fig. 15 which shows relationships between supplied current I and light power P in the apparatus of Fig. 4.

During a read mode, the main controller 14 generates a gate signal WGT2 (= "0"), and accordingly the gate circuit 8 generates a first gate signal W̅G̅T̅ (= "1"), a second gate signal WGT (= "0"), a third gate signal WGT.WDT (= "0"), and a fourth gate signal W̅G̅T̅.HFM + WGT.WDT = HFM. The switches 71 and 73 are turned ON, and the switches 72 and 74 turned OFF by the first gate signal WGT and the second gate signal WGT. Therefore, 0 V is applied to the control current source 2′-2, and the read peak voltage V_{R} is applied to the control current source 2′-3. The current switch 10 is turned OFF by the third gate signal WGT.WDT (= "0"), and therefore no monitored output current I_{M} is absorbed in the control current source 9. The current switch 3′ is switched at a frequency of a high frequency signal HFM by serving as the fourth gate signal. As a result, a pulsed current between I = Iₜₕ and I = Iₜₕ + I_{HFM} is supplied to the laser diode 1, and accordingly a pulsed read peak output power P_{HFM} appears as shown in Fig. 15. In this case, a mean value P̅ of a light power P is brought close to the base read output P_{R} by automatic power control operation of the APC circuit 4, as shown in Fig. 15.

During a write mode for data "0", the main controller 14 generates a gate signal WGT2 (= "1") and a data signal WDT2 (= "0"), and the gate circuit 8 generates a first gate signal W̅G̅T̅ (= "0"), a second gate signal WGT (= "1"), a third gate signal WGT.WDT (= "0"), and a fourth gate signal W̅G̅T̅.HFM + WGT.WDT (= "0"). The switches 72 and 74 are turned ON, and the switches 71 and 73 are turned OFF by the first gate signal W̅G̅T̅ and the second gate signal WGT. Therefore, the voltage V_{R} is applied to the control current source 2′-2, and the voltage V_{M} is applied to the control current source 2′-3. The current switch 10 is turned OFF by the third gate signal WGT.WDT (= "0"), and therefore no monitored output current I_{M} is absorbed in the control current source 9. The current switch 3′ is turned OFF by the fourth gate signal W̅G̅T̅.HFM + WGT.WDT (= "0"). As a result, a current I = Iₜₕ + I_{R} is supplied to the laser diode 1, and accordingly, the base read output P_{R} appears as shown in Fig. 15. In this case, a light power P₁ is brought close to the base read output P_{R} by operation of the APC circuit 4, as shown in Fig. 15.

During a write mode for data "1", the main controller 14 generates a gate signal WGT2 (= "1") and a data signal WDT2 (= "1"), and the gate circuit 8 generates a first gate signal W̅G̅T̅ (= "0"), a second gate signal WGT (= "1"), a third gate signal WGT.WDT (= "1"), and a fourth gate signal W̅G̅T̅.HFM + WGT.WDT (= "1"). The switches 72 and 74 are turned ON, and the switches 71 and 73 are turned OFF by the first gate signal W̅G̅T̅ and the second gate signal WGT. Therefore, the voltage V_{R} is applied to the control current source 2′-2, and the voltage V_{W} is applied to the control current 2′-3. The current switch 10 is turned ON by the third gate signal WGT.WDT (= "1"), and therefore a monitored output current I_{M} is absorbed in the control current source 9. The current switch 3′ is turned ON by the fourth gate signal W̅G̅T̅.HFM + WGT.WDT (= "1"). As a result, a current I = Iₜₕ + I_{R} + I_{W} is supplied to the laser diode 1, and accordingly the write output power P_{W} appears as shown in Fig. 15. In this case, a light power P₂, which is equal to the write output power P_{W} minus ΔP corresponding to the write current I_{W}, is brought close to the base read output power P_{R} by operation of the APC circuit 4, as shown in Fig. 15.

During an erase mode, the main controller 14 always generates a gate signal WGT2 (= "1") and a data signal WDT2 (= "1"), in the same way as during a write mode for data "1". Therefore, a current I = Iₜₕ + I_{R} + I_{W} is supplied to the laser diode 1, and accordingly, the write output power P_{W} also appears. Also, in this case, a light power P₂, which is equal to the write output power P_{W} minus ΔP corresponding to the write current I_{W}, is brought close to the based read output power P_{R} by operation of the APC circuit 4.

As shown in Fig. 15, the following condition is satisfied:${\text{I}}_{\text{R}} {\text{< I}}_{\text{HFM}} {\text{< I}}_{\text{R}} {\text{+ I}}_{\text{W}} \text{.}$

Also, as shown in Fig. 15, the mean value P̅ of the light power P during a read mode coincides with the light power P₁ and P₂ during a write mode. Note that both the light power P̅ and P₁ (P₂) are brought close to the base read output power P_{R}. Therefore, at a switching between a read mode and a write mode (also erase mode), automatic power control by the APC circuit 4 is hardly caused to fluctuate.

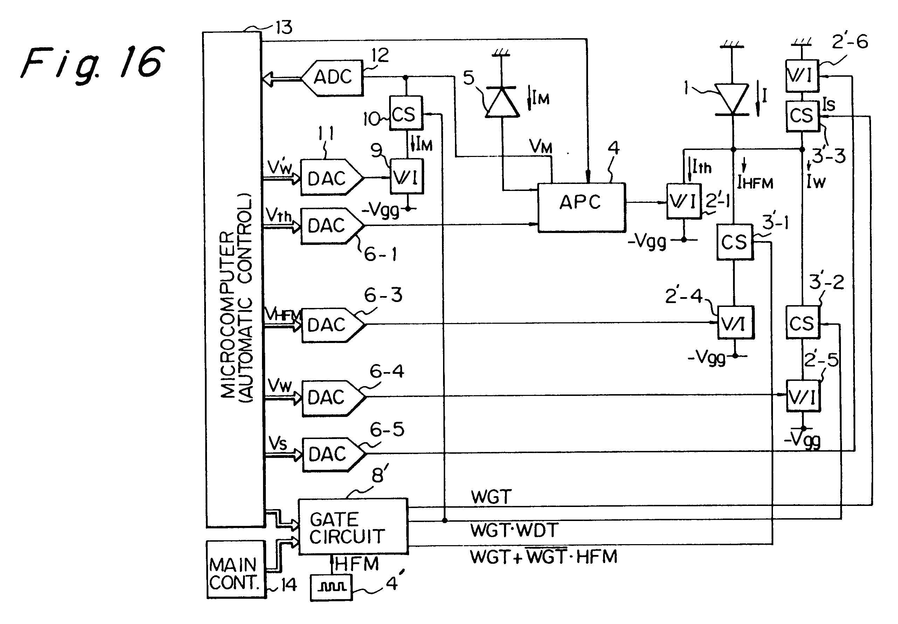

In Fig. 16, which relates to a second embodiment of the present invention, three control current sources 2′-4, 2′-5 and 2′-6 are provided instead of the control current sources 2′-2 and 2′-3 of Fig. 4, and current switches 3′-1, 3′-2 and 3′-3 are connected in series with the control current sources 2′-4, 2′-5 and 2′-6, respectively. Also, the switching circuit 7-1 and 7-2 and the D/A converter 6-2 of Fig. 4 are omitted and a D/A converter 6-5 is added.

The control current source 2′-4 is used for supplying a read peak current I_{HFM} to the laser diode 1 during a read mode. Therefore, the read peak voltage VHFM is applied by the D/A converter 6-3 to the control current source 2′-4 and the current switch 3′-1 is turned ON in accordance with the high frequency signal HFM during a read mode (W̅G̅T̅ = "1"). However, the current switch 3′-1 is turned ON even during a write mode (WGT = "1").

The control current source 2′-5 is used for supplying the write current I_{W} during a write mode for data "1". Therefore, the write voltage V_{W} for the write current I_{W} is applied by the D/A converter 6-4 to the control current source 2′-5, and the current switch 3′-2 is turned ON during a write mode for data "1" (WGT = WDT = "1").

The control current source 2′-6 is used for supplying a correction current I_{S} to the control current sources 2′-1, 2′-4 and 2′-5, i.e. for subtracting the correction current I_{S} from a current I flowing through the laser diode 1 during a write mode. Therefore, a correction voltage V_{S} is applied by the D/A converter 6-5 to the control current source 3′-3, and the current switch 2′-6 is turned ON during a write mode (WGT = "1").

A gate circuit 8′ is obtained by modifying the gate circuit 8 of Fig. 4.

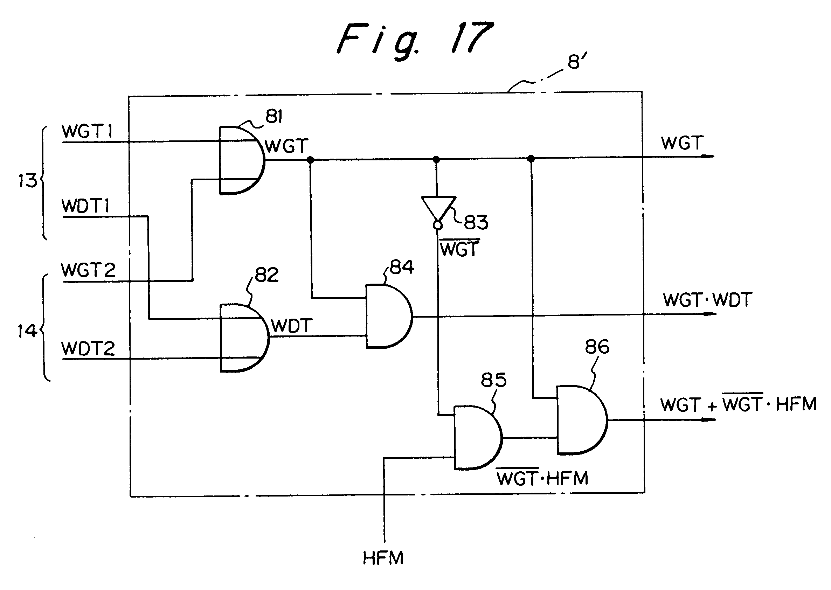

In Fig. 17, which is a detailed circuit diagram of the gate circuit 8′ of Fig. 16, an OR circuit 86 is different from the OR circuit 86 of Fig. 5. That is, the OR circuit 86′ is connected to the outputs of the OR circuit 81 and the AND circuit 85. Therefore, the OR circuit 86′ generates a gate signal WGT + W̅G̅T̅.HFM. Also, the gate circuit 8′ does not generate the gate signal W̅G̅T̅.

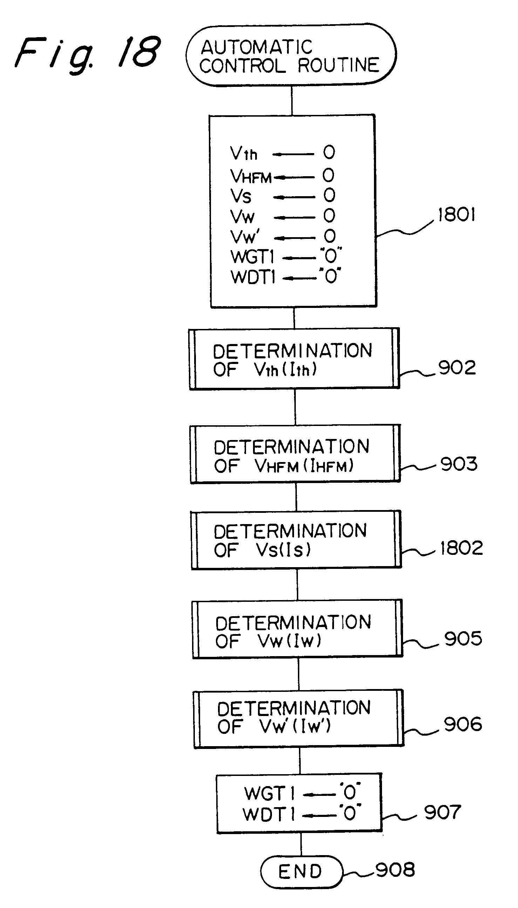

An automatic control by the microcomputer 13 in Fig. 16 is illustrated in Fig. 18. That is, steps 1801 and 1802 are provided instead of steps 901 and 902 of Fig. 9. At step 1801, the value V_{S} instead of the value V_{R} is cleared. Also, at step 1802, the value V_{S} for the correction current I_{S} for the D/A converter 6-5 is determined.

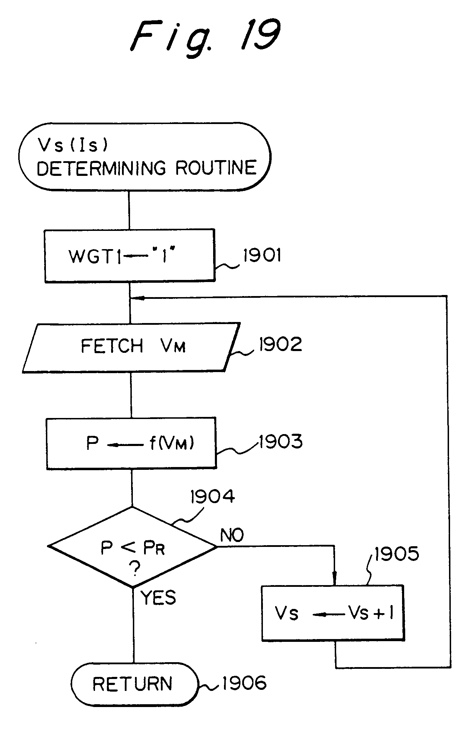

In Fig. 19, which is a detailed flowchart of the V_{S} (I_{S}) determining step 1802, at step 1901, the gate signal WGT1 is set (WGT1 = "1"), i.e. the gate signal WGT is set (WGT = "1"). As a result, the current switch 3′-1 is turned ON, and accordingly, the read peak current I_{HFM} is supplied as a direct current to the laser diode 1. Also, the current switch 3′-3 is turned ON, and accordingly a correction current I_{S} corresponding to the correction voltage V_{S}, which is initially 0 V, flows through the control current source 2′-6. Also the gate signal WGT.WDT of the gate circuit 8′ represents "0", since WDT = "0". Thus, the current switch 3′-2 is turned OFF. Therefore, a current I = Iₜₕ + I_{HFM} - I_{S} is supplied to the laser diode 1. Here I_{S} = 0.

At step 1902, a monitored output voltage V_{M} is fetched from the A/D converter 12, and at step 1903, a power P of the laser diode 1 is calculated from this output voltage V_{M} in accordance with the predetermined function f.

At step 1904, it is determined whether or not P is smaller than P_{R}, i.e. whether or not the light power P reaches the base read output power P_{R}. As a result, if P ≧ P_{R}, the control proceeds to step 1905 which increases the value V_{S} by a definite value such as 1, and steps 1902 to 1904 are then repeated. Otherwise, control proceeds to step 1906, thereby completing the routine of Fig. 19. Thus, the value V_{S} for the correction current I_{S} is finally determined by the routine of Fig. 19, and is stored in the RAM.

Also, note that when carrying out the V_{W} (I_{W}) determining step 905 and V_{W}′ (I_{W}′) determining step 906, a current I = Iₜₕ + I_{HFM} - I_{S} + I_{W} is supplied to the laser diode 1.

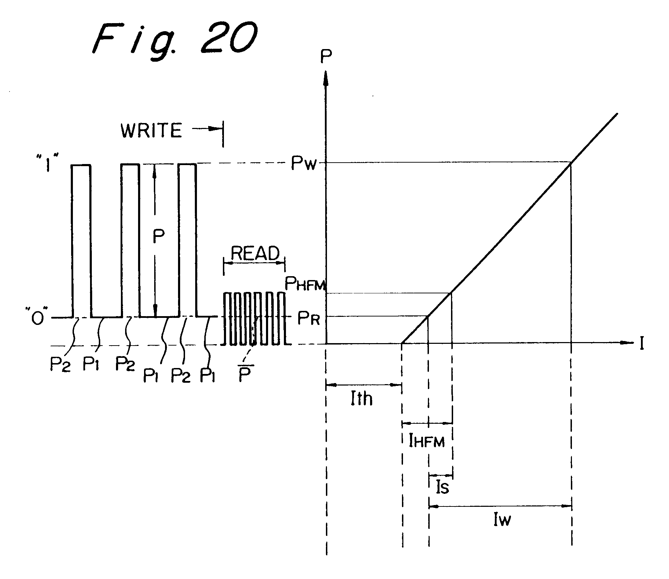

The operation of the main controller 14 of Fig. 16 will be explained with reference to Fig. 20, which shows relationships between supplied current I and light power P in the apparatus of Fig. 16.

During a read mode, the main controller 14 generates a gate signal WGT2 (= "0"), and accordingly the gate circuit 8' generates a first gate signal WGT (= "0"), a second gate signal WGT.WDT (= "0"), and a third gate signal WGT + W̅G̅T̅.HFM = HFM. The current switch 3′-3 is turned OFF by the first gate signal WGT (= "0"), and accordingly the correction current I_{S} does not flow. The current switch 3′-2 and 10 are turned OFF by the second gate signal WGT.WDT (= "0"), and accordingly the write current I_{W} and the current I_{W}′ do not flow.

The current switch 3′-1 is switched by a frequency of the high frequency signal HFM by the third gate signal HFM. As a result, a pulsed current between I = Iₜₕ and I = Iₜₕ + I_{HFM} is supplied to the laser diode 1, and accordingly, a pulsed read peak output power P_{HFM} appears as shown in Fig. 20. In this case, a mean value P̅ of the light power P is brought close to the base read output power P_{R} by operation of the APC circuit 4, as shown in Fig. 20.

During a write mode for data "0", the main controller 14 generates a gate signal WGT2 (= "1") and a data signal WDT2 (= "0"), and the gate circuit 8′ generates a first gate signal WGT (= "1"), a second gate signal WGT.WDT (= "0"), and a third gate signal WGT + W̅G̅T̅.HFM (= "1"). The current switch 3′-3 is turned ON by the first gate signal WGT (= "1"), and accordingly, the correction current I_{S} flows through the control current source 2′-6. The current switches 3′-2 and 10 are turned OFF by the second gate signal WGT.WDT (= "0"), and accordingly, the write current I_{W} and the current I_{W}′ do not flow. As a result, a current I = Iₜₕ + I_{HFM} - I_{S} is supplied to the laser diode 1, and accordingly, the base read output power P_{R} appears as shown in Fig. 20. In this case, a light power P₁ is brought close to the base read output power P_{R} by operation of the automatic power control (APC) circuit 4, as shown in Fig. 20.

During a write mode for data "1", the main controller 14 generates a gate signal WGT2 (= "1") and a data signal WDT2 (= "1"), and the gate circuit 8′ generates a first gate signal WGT (= "1"), a second gate signal WGT.WDT (= "1"), and a third gate signal WGT + W̅G̅T̅.HFM (= "1"). The current switch 3′-3 is turned ON by the first gate signal WGT (= "1"), and accordingly, the correction current I_{S} flows through the control current source 2′-6. The current switches 3′-2 and 10 are turned ON by the second gate signal WGT.WDT (= "1"), and accordingly, the write current I_{W} is supplied to the laser diode 1 and the current I_{W}′ in the monitored output current I_{M} is absorbed by the control current source 9. The current switch 3′-1 is turned ON by the third gate signal WGT + W̅G̅T̅.HFM (= "1"), and accordingly, the write current I_{W} is supplied to the laser diode 1. As a result, a current I = Iₜₕ + I_{HFM} - I_{S} + I_{W} is supplied to the laser diode 1, and accordingly, the write output power P_{W} appears as shown in Fig. 20. In this case, a light power P₂, which is equal to the light power P_{W} minus ΔP corresponding to the write current I_{W}, is brought close to the based read output power P_{R} by operation of the APC circuit 4, as shown in Fig. 20.

During an erase mode, the main controller 14 always generates a gate signal WGT2 (= "1") and a data signal WDT2 (= "1"), in the same way as during a write mode for data "1". Therefore, a current I = Iₜₕ + I_{HFM} - I_{S} + I_{W} is supplied to the laser diode 1, and accordingly the write output power P_{W} also appears. Also, in this case, a light power P₂, which is equal to the light power P_{W} minus ΔP corresponding to the write current I_{W}, is brought close to the base read output power P_{R} by operation of the APC circuit 4.

As shown in Fig. 20, the following condition is satisfied:${\text{I}}_{\text{HFM}} {\text{- I}}_{\text{S}} {\text{< I}}_{\text{HFM}} {\text{< I}}_{\text{HFM}} {\text{- I}}_{\text{S}} {\text{+ I}}_{\text{W}}$

Also, as shown in Fig. 20, the mean value P̅ of the light power P during a read mode coincides with the light power P₁ and P₂ during a write mode. Note that both the light power P̅ and P₁ (P₂) are brought close to the base read output P_{R}. Therefore, when switching between a read mode and a write mode (also erase mode), automatic power control by the APC circuit 4 is hardly caused to fluctuate.

In the above-mentioned embodiments, the value Iₜₕ is determined by a threshold current of the laser diode 1 which initiates emitting of light therefrom. However, the value Iₜₕ can be smaller than such a threshold current.

In an apparatus embodying the present invention, fluctuations of an APC at a switching between a read mode and a write mode (or erase mode) can be avoided, to increase an access speed to an optical storage medium.

## Claims

1. Laser diode control circuitry, for driving a laser diode (1) to emit light for reading digitally recorded data from an optical storage medium and recording data digitally on that medium, comprising:
first current supply means (2′-1) operable to supply a first direct current (Iₜₕ) continually to the laser diode during such reading and recording;
second current supply means (2′-2) connected for supplying a second direct current (I_{R}) continually to the laser diode during such recording, so that the power output of the laser diode due to the said first and second direct currents together is substantially equal to a preselected base read power (P_{R});
third current supply means (2′-3, 3′, 6-3, 73) operable to supply a third current (I_{HFM}), pulsed at a high frequency, continually to the laser diode during such reading;
light power monitoring means (5), arranged to receive light emitted by the laser diode, for providing an output depending on the received light power;
automatic power control means (4), connected between the said light power monitoring means (5) and the said first current supply means (2′-1), operable to control the magnitude of the said first direct current, during such reading, so as to maintain the mean value of the optical output power of the laser diode substantially equal to the said base read power (P_{R});
fourth current supply means (2′-3, 3′, 6-4, 74), for supplying a fourth direct current (I_{W}) to the laser diode, in addition to the said first and second direct currents (Iₜₕ, I_{R}), when data is to be recorded on the said medium; and
switching means (3′, 8) operable to switch the said fourth current supply means on and off in accordance with write data to be recorded on the said medium.

2. Laser diode control circuitry as claimed in claim 1, wherein the said first direct current (Iₜₕ) is less than or equal to a minimum current at which the laser diode is able to emit light.

3. Laser diode control circuitry as claimed in claim 1 or 2, further comprising means (13, 6-3) for determining, during an initialization procedure of the circuitry, a value of the said third current (I_{HFM}) at which the mean power output of the laser diode, due to the said first current (Iₜₕ) together with the high-frequency pulsed third current (I_{HFM}), substantially equals the said base read power (P_{R}).

4. Laser diode control circuitry as claimed in any preceding claim, further comprising current absorbing means (9, 10, 11) for cancelling the effect, on the automatic power control means (4), of the diode light output due to the said fourth direct current (I_{W}) when data is being recorded on the said medium, thereby enabling the said automatic power control means (4) to control the magnitude of the said first direct current (Iₜₕ), during such recording, so as to maintain the mean value of the optical output power of the laser diode, due to the said first direct current (Iₜₕ) together with the second direct current (I_{R}), substantially equal to the said base read power (P_{R}).

5. Laser diode control circuitry, for driving a laser diode to emit light for reading digitally recorded data from an optical storage medium and recording data digitally on that medium, comprising:
first current supply means (2′-1, 6-1) operable to supply a first direct current (Iₜₕ) continually to the laser diode during such reading and recording;
second current supply means (2′-4, 3′-1, 6-3) operable to supply a second current (I_{HFM}) continually to the laser diode during such recording and to supply that second current, pulsed at a high frequency, to the laser diode during such reading;
light power monitoring means (5), arranged to receive light emitted by the laser diode, for providing an output depending on the received light power;
automatic power control means (4), connected between the said light power monitoring means and the said first current supply means, operable to control the magnitude of the said first direct current (Iₜₕ), during such reading, so as to maintain the mean value of the optical output power of the laser diode substantially equal to a preselected base read power (P_{R});
third current supply means (2′-5, 3′-2, 6-4), for supplying a third current (I_{W}) to the laser diode, in addition to the said first and second currents (Iₜₕ, I_{HFM}), when data is to be recorded on the said medium;
switching means (3′-2, 8′) operable to switch the said third current supply means on and off in accordance with write data to be recorded on the said medium: and
current absorbing means (2′-6, 3′-3) for partially cancelling the effect, on the optical power output of the laser diode, of the second current (I_{HFM}) when data is being recorded on the said medium, so that the said power output of the laser diode is substantially equal to a predetermined write power (P_{W}).

6. Laser diode control circuitry as claimed in claim 5, wherein the said first direct current (Iₜₕ) is less than or equal to a minimum current at which the laser diode is able to emit light.

7. Laser diode control circuitry as claimed in claim 5 or 6, further comprising means (13, 6-3) for determining, during an initialization procedure of the circuitry, a value of the said second current (I_{HFM}) at which the mean power output of the laser diode, due to the said first current (Iₜₕ) together with the high-frequency pulsed second current (I_{HFM}), substantially equals the said base read power (P_{R}).

8. Laser diode control circuitry as claimed in claim 5, 6 or 7, further comprising further current absorbing means (9, 10, 11) for cancelling the effect, on the automatic power control means (4), of the diode light output due to the said third direct current (I_{W}) when a data "1" is being recorded on the said medium, thereby enabling the said automatic power control means (4) to control the magnitude of the said first direct current (Iₜₕ) during such recording, so as to maintain the mean value of the optical output power of the laser diode, due to the said first direct current together with the partially cancelled second current (I_{HFM}), substantially equal to the said base read power (P_{R}).

## Patentansprüche

1. Laserdiodenregelkreis zum Treiben einer Laserdiode (1), damit sie Licht zum Lesen von auf einem optischen Speichermedium digital aufgenommenen Daten emittiert, und zum digitalen Aufnehmen von Daten auf das Medium, mit:
einem ersten Stromversorgungsmittel (2′-1), das betrieben werden kann, um einen ersten Gleichstrom (Iₜₕ) während eines derartigen Lesens und Aufnehmens kontinuierlich an die Laserdiode anzulegen;
einem zweiten Stromversorgungsmittel (2′-2), das angeschlossen ist, um einen zweiten Gleichstrom (I_{R}) während eines derartigen Aufnehmens kontinuierlich an die Laserdiode anzulegen, so daß der Leistungsausgang der Laserdiode infolge der genannten ersten und zweiten Gleichströme zusammen im wesentlichen einer zuvor ausgewählten Basisleseleistung (P_{R}) entspricht;
einem dritten Stromversorgungsmittel (2′-3, 3′, 6-3, 73), das betrieben werden kann, um einen dritten Strom (I_{HFM}), der mit einer hohen Frequenz gepulst ist, kontinuierlich an die Laserdiode während eines derartigen Lesens anzulegen;
einem Lichtleistungs-Überwachungsmittel (5), das angeordnet ist, um von der Laserdiode emittiertes Licht zu empfangen, um einen Ausgang bereitszustellen, der von der empfangenen Lichtleistung abhängig ist;
einem automatischen Leistungsregelungsmittel (4), das zwischen dem genannten Lichtleistungs-Überwachungsmittel (5) und dem genannten ersten Stromversorgungsmittel (2′-1) verbunden ist, das betrieben werden kann, um die Größe des genannten ersten Gleichstromes während eines derartigen Lesens zu regeln, um den Mittelwert der optischen Ausgangsleistung der Laserdiode im wesentlichen gleich der genannten Basisleseleistung (P_{R}) zu halten;
einem vierten Stromversorgungsmittel (2′-3, 3′, 6-4, 74) zum Anlegen eines vierten Gleichstromes (I_{W}) an die Laserdiode, zusätzlich zu den genannten ersten und zweiten Gleichströmen (Iₜₕ, I_{R}), wenn Daten auf das genannte Medium aufzunehmen sind; und
einem Schaltmittel (3′, 8), das betrieben werden kann, um das genannte vierte Stromversorgungsmittel in Übereinstimmung mit auf das genannte Medium aufzunehmende Schreibdaten ein- und auszuschalten.

2. Laserdiodenregelkreis nach Anspruch 1, worin der genannte erste Gleichstrom (Iₜₕ) kleiner oder gleich einem Minimalstrom ist, bei dem die Laserdiode in der Lage ist, Licht zu emittieren.

3. Laserdiodenregelkreis nach Anspruch 1 oder 2, der desweiteren Mitteln (13, 6-3) umfaßt, um, während eines Initialisierungsvorganges des Schaltkreises, einen Wert des genannten dritten Stromes (I_{HFM}) zu bestimmen, bei dem der mittlere Leistungsausgang der Laserdiode, infolge des genannten ersten Stromes (Iₜₕ) zusammen mit dem Hochfrequenz-gepulsten dritten Strom (I_{HFM}) im wesentlichen der genannten Basisleseausgangsleistung (P_{R}) entspricht.

4. Laserdiodenregelkreis nach einem der vorigen Ansprüche, der desweiteren ein stromabsorbierendes Mittel (9, 10, 11) umfaßt, um den Einfluß des Diodenlichtausganges infolge des genannten vierten Gleichstromes (I_{W}) auf das automatische Leistungssteuermittel (4) aufzuheben, wenn Daten auf das genannte Medium aufgenommen werden, wodurch das genannte automatische Leistungssteuermittel (4) in die Lage gesetzt wird, die Stärke des genannten ersten Gleichstromes (Iₜₕ) während einer derartigen Aufnahme zu steuern, um den Mittelwert der optischen Ausgangsleistung der Laserdiode, infolge des genannten ersten Gleichstromes (Iₜₕ) zusammen mit dem zweiten Gleichstrom (I_{R}), im wesentlichen gleich der genannten Basisleseausgangsleistung (P_{R}) zu halten.

5. Laserdiodenregelkreis zum Treiben einer Laserdiode, damit sie Licht zum Lesen von auf einem optischen Speichermedium digital aufgenommenen Daten emittiert, und zum digitalen Aufnehmen von Daten auf das Medium, mit:
einem ersten Stromversorgungsmittel (2′-1, 6-1), das betrieben werden kann, um einen ersten Gleichstrom (Iₜₕ) während eines derartigen Lesens und Aufnehmens kontinuierlich an die Laserdiode anzulegen;
einem zweiten Stromversorgungsmittel (2′-4, 3′-1, 6-3), das betrieben werden kann, um einen zweiten Strom (I_{HFM}) während eines derartigen Aufnehmens kontinuierlich an die Laserdiode anzulegen und um diesen zweiten Strom, der mit einer hohen Frequenz gepulst ist, während eines derartigen Lesens an die Laserdiode anzulegen;
einem Lichtleistungs-Überwachungsmittel (5), das angeordnet ist, um von der Laserdiode emittiertes Licht zu empfangen, zum Bereitstellen eines Ausganges, der von der empfangenen Lichtleistung abhängig ist;
einem automatischen Leistungsregelungsmittel (4), das zwischen dem genannten Lichtleistungs-Überwachungsmittel und dem genannten ersten Stromversorgungsmittel (Iₜₕ) verbunden ist, das betrieben werden kann, um die Größe des genannten ersten Gleichstromes während eines derartigen Lesens zu regeln, um den Mittelwert der optischen Ausgangsleistung der Laserdiode im wesentlichen gleich einer vorhergewählten Basisleseleistung (P_{R}) zu halten;
einem dritten Stromversorgungsmittel (2′-5, 3′-2, 6-4) zum Anlegen eines dritten Stromes (I_{W}) an die Laserdiode, zusätzlich zu den genannten ersten und zweiten Strömen (Iₜₕ, I_{HFM}), wenn Daten auf das genannte Medium aufzunehmen sind;
einem Schaltmittel (3′-2, 8′), das betrieben werden kann, um das genannte dritte Stromversorgungsmittel in Übereinstimmung mit auf das genannte Medium aufzunehmende Schreibdaten ein- und auszuschalten; und
einem Stromabsorptionsmittel (2′-6, 3′-3), um den Einfluß des zweiten Stromes (I_{HFM}) auf die optische Ausgangsleistung der Laserdiode zum Teil aufzuheben, wenn Daten auf das genannte Medium aufgenommen werden, so daß die genannte Ausgangsleistung der Laserdiode im wesentlichen gleich einer vorherbestimmten Schreibleistung (P_{W}) ist.

6. Laserdiodenregelkreis nach Anspruch 5, worin der genannte erste Gleichstrom (Iₜₕ) kleiner oder gleich einem Minimalstrom ist, bei dem die Laserdiode in der Lage ist, Licht zu emittieren.

7. Laserdiodenregelkreis nach Anspruch 5 oder 6, der desweite ren Mittel (13, 6-3) umfaßt, um, während eines Initialisierungsvorgangs des Schaltkreises, einen Wert des genannten zweiten Stromes (I_{HFM}) zu bestimmen, bei dem der mittlere Leistungsausgang der Laserdiode, infolge des genannten ersten Stromes (Iₜₕ) zusammen mit dem Hochfrequenz-gepulsten zweiten Strom (I_{HFM}) im wesentlichen gleich der genannten Basisleseleistung (P_{R}) ist.

8. Laserdiodenregelkreis nach Anspruch 5, 6 oder 7, der desweiteren ein stromabsorbierendes Mittel (9, 10, 11) umfaßt, um den Einfluß des Diodenlichtausganges infolge des genannten dritten Gleichstromes (I_{W}) auf das automatische Leistungssteuermittel (4) aufzuheben, wenn ein Datum "1" auf das genannte Medium aufgenommen wird, wodurch das genannten automatische Leistungssteuermittel (4) in die Lage versetzt wird, die Stärke des genannten ersten Gleichstromes (Iₜₕ) während einer derartigen Aufnahme zu steuern, um den Mittelwert der optischen Ausgangsleistung der Laserdiode, infolge des genannten ersten Gleichstromes zusammen mit dem teilweise aufgehobenen zweiten Strom (I_{HFM}) im wesentlichen gleich der genannten Basisleseleistung (P_{R}) zu halten.

## Revendications

1. Circuit de commande de diode laser pour commander une diode laser (1) pour émettre une lumière afin de lire de façon numérique des données enregistrées sur un support d'enregistrement optique et afin d'enregistrer des données de façon numérique sur ce support, comprenant :
des premiers moyens d'alimentation en courant (2′ -1) servant à appliquer un premier courant continu (Iₜₕ) de façon continue à la diode laser au cours d'une telle lecture et d'un tel enregistrement ;
des seconds moyens d'alimentation en courant (2′ - 2) connectés en vue d'appliquer un second courant continu (I_{R}) de façon continue à la diode laser au cours d'un tel enregistrement, de manière à ce que la sortie de puissance de la diode laser due aux premier et second courants continus ensemble soit sensiblement égale à une puissance de lecture de base présélectionnée (P_{R}) ;
des troisièmes moyens d'alimentation en courant (2′ - 3, 3′, 6 - 3, 73) servant à appliquer un troisième courant (I_{HFM}), pulsé à une haute fréquence, de façon continue, à la diode laser au cours d'une telle lecture ;
des moyens de surveillance de puissance de lumière (5), agencés de manière à recevoir une lumière émise par la diode laser, pour générer une sortie en fonction de la puissance de lumière reçue ;
des moyens de commande automatique de puissance (4), connectés entre lesdits moyens de surveillance de puissance de lumière (5) et lesdits premiers moyens d'alimentation en courant (2′ - 1), servant à commander l'amplitude dudit premier courant continu, au cours d'une telle lecture, de manière à maintenir la valeur moyenne de la puissance de sortie optique de la diode laser sensiblement égale à ladite puissance de lecture de base (P_{R}) ;
des quatrième moyens d'alimentation en courant (2′ - 3, 3′, 6 - 4, 74), pour appliquer un quatrième courant continu (I_{W}) à la diode laser, en plus desdits premier et second courants continus (Iₜₕ, I_{R}), lorsque des données doivent être enregistrées sur ledit support ; et
des moyens de commutation (3′, 8) servant à activer et à désactiver lesdits quatrièmes moyens d'alimentation en courant en fonction des données d'écriture devant être enregistrées sur ledit support.

2. Circuit de commande de diode laser selon la revendication 1, dans lequel ledit premier courant continu (Iₜₕ) est inférieur ou égal à un courant minimum pour lequel la diode laser peut émettre une lumière.

3. Circuit de commande de diode laser selon la revendication 1 ou 2, comprenant en outre des moyens (13, 6 - 3) pour déterminer, au cours d'une procédure d'initialisation du circuit, une valeur dudit troisième courant (I_{HFM}) pour laquelle la sortie de puissance moyenne de la diode laser, due audit premier courant (Iₜₕ) ensemble avec le troisième courant pulsé haute fréquence (I_{HFM}), est sensiblement égale à ladite puissance de lecture de base (P_{R}).

4. Circuit de commande de diode laser selon l'une quelconque des revendications précédentes, comprenant en outre des moyens d'absorption de courant (9, 10, 11) pour annuler l'effet, sur les moyens de commande automatique de puissance (4), de la sortie de lumière de diode due audit quatrième courant continu (I_{W}) lorsque des données sont en train d'être enregistrées sur ledit support, permettant ainsi auxdits moyens de commande automatique de puissance (4) de commander l'amplitude dudit premier courant continu (Iₜₕ), au cours d'un tel enregistrement, de manière à maintenir la valeur moyenne de la puissance de sortie optique de la diode laser, due audit premier courant continu (Iₜₕ) ensemble avec le second courant continu (I_{R}), sensiblement égale à ladite puissance de lecture de base (P_{R}).

5. Circuit de commande de diode laser pour commander une diode laser de manière à ce qu'elle émette une lumière permettant de lire de façon numérique des données enregistrées sur un support d'enregistrement optique et permettant d'enregistrer des données de façon numérique sur ce support, comprenant :
des premiers moyens d'alimentation en courant (2′ - 1, 6 - 1) servant à appliquer un premier courant continu (Iₜₕ) de façon continue à la diode laser au cours d'une telle lecture et d'un tel enregistrement ;
des seconds moyens d'alimentation en courant (2′ - 4, 3′-1, 6 - 3) servant à appliquer un second courant (I_{HFM}) de façon continue à la diode laser au cours d'un tel enregistrement et servant à appliquer ce second courant, pulsé haute fréquence, à la diode laser au cours d'une telle lecture ;
des moyens de surveillance de puissance de lumière (5), agencés de manière à recevoir une lumière émise par la diode laser, pour générer une sortie en fonction de la puissance de lumière reçue ;
des moyens de commande automatique de puissance (4) connectés entre lesdits moyens de surveillance de puissance de lumière et lesdits premiers moyens d'alimentation en courant, servant à commander l'amplitude dudit premier courant continu (Iₜₕ) au cours d'une telle lecture, de manière à maintenir la valeur moyenne de la puissance de sortie optique de la diode laser sensiblement égale à une puissance de lecture de base présélectionnée (P_{R}) ;
des troisièmes moyens d'alimentation en courant (2′ - 5, 3′ - 2, 6 - 4) pour appliquer un troisième courant (I_{W}) à la diode laser, en plus desdits premier et second courants (Iₜₕ, I_{HFM}), lorsque des données doivent être enregistrées sur ledit support ;
des moyens de commutation (3′ - 2, 8′) servant à activer et à désactiver lesdits troisièmes moyens d'alimentation en courant en fonction des données d'écriture devant être enregistrées sur ledit support ; et
des moyens d'absorption de courant (2′ - 6, 3′ - 3) pour annuler partiellement l'effet, sur la sortie de puissance optique de la diode laser, du second courant (I_{HFM}) lorsque des données sont en train d'être enregistrées sur ledit support, de manière à ce que ladite sortie de puissance de la diode laser soit sensiblement égale à une puissance d'écriture prédéterminée (P_{W}).

6. Circuit de commande de diode laser selon la revendication 5, dans lequel ledit premier courant continu (Iₜₕ) est inférieur ou égal à un courant minimum pour lequel la diode laser peut émettre une lumière.

7. Circuit de commande de diode laser selon la revendication 5 ou 6, comprenant en outre des moyens (13, 6 - 3) pour déterminer, au cours d'une procédure d'initialisation du circuit, une valeur dudit second courant (I_{HFM}) pour laquelle la sortie de puissance moyenne de la diode laser, due audit premier courant (Iₜₕ) ensemble avec le second courant pulsé haute fréquence (I_{HFM}), est sensiblement égale à ladite puissance de lecture de base (P_{R}).

8. Circuit de commande de diode laser selon la revendication 5, 6 ou 7, comprenant en outre des moyens d'absorption de courant supplémentaires (9, 10, 11) pour annuler l'effet, sur les moyens de commande automatique de puissance (4), de la sortie de lumière de diode due audit troisième courant continu (I_{W}) lorsqu'une donnée "1" est en train d'être enregistrée sur ledit support, permettant ainsi auxdits moyens de commande automatique de puissance (4) de commander l'amplitude dudit premier courant continu (Iₜₕ) au cours d'un tel enregistrement, de manière à maintenir la valeur moyenne de la puissance de sortie optique de la diode laser, due audit premier courant continu ensemble avec le second courant annulé partiellement (I_{HFM}), sensiblement égale à ladite puissance de lecture de base (P_{R}).
